# EUROPEAN PATENT APPLICATION

(11) **EP 3 671 331 A1**
(43) Date of publication of application: **24.06.2020**
(21) Application number: 18846203.0
(22) Date of filing: 15.05.2018
(51) Int. Cl.: G02F 1/1335

(54) **ARRAY SUBSTRATE, METHOD FOR MANUFACTURING SAME, AND DISPLAY PANEL**

(30) Priority: 17.08.2017 CN 201710707687
(71) Applicant: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: CAO, Binbin, Beijing 100176 (CN)
(74) Representative: Jacobacci Coralis Harle
(86) International application number: PCT/CN2018/086872
(87) International publication number: WO 2019/033802

(57) **Abstract**

Embodiments of the present disclosure relate to an array substrate, a method for manufacturing the same, and a display panel thereof. The array substrate includes: a transparent substrate having a first side surface and a second side surface opposite to the first side surface; and a light reflecting structure located on the first side surface of the transparent substrate, wherein the second side surface of the transparent substrate has a coarse region, an orthographic projection of the coarse region on the transparent substrate coinciding with an orthographic projection of the light reflecting structure on the transparent substrate.

## Description

### CROSS-REFERENCE TO RELATED APPLICATIONS

This application claims priority of China Patent Application No. 201710707687.6, filed on August 17, 2017, the entire content of which is incorporated herein by reference as part of this application.

### BACKGROUND

The present disclosure relate to the field of display technologies, and in particular, to an array substrate, a method for manufacturing the same and a display panel thereof.

At present, in order to increase the size of the display screen without increasing the size of the electronic device, more and more manufacturers are working on the display screen without a frame.

### BRIEF DESCRIPTION

Embodiments of the present disclosure provide an array substrate, a method for manufacturing the same, and a display panel thereof.

According to a first aspect of an embodiment of the present disclosure, there is provided an array substrate. The array substrate includes: a transparent substrate having a first side surface and a second side surface opposite to the first side surface; and a light reflecting structure disposed on the first side surface of the transparent substrate, wherein the second side surface of the transparent substrate has a coarse region, an orthographic projection of the coarse region on the transparent substrate coinciding with an orthographic projection of the light reflecting structure on the transparent substrate.

In an embodiment of the present disclosure, the coarse region is a portion of a base material of the transparent substrate.

In an embodiment of the present disclosure, the light reflecting structure includes a black matrix and a conductive structure.

In an embodiment of the present disclosure, the conductive structure includes at least one of a data line, a data lead, a gate line, and a gate lead formed on the transparent substrate.

In an embodiment of the present disclosure, the base material of the transparent substrate is glass.

According to a second aspect of an embodiment of the present disclosure, there is provided a display panel including the array substrate described in the first aspect of the embodiment of the present disclosure.

According to a third aspect of embodiments of the present disclosure, there is provided a method for manufacturing an array substrate. The method includes: providing a transparent substrate having a first side surface and a second side surface opposite to the first side surface, a light reflecting structure being disposed on the first side surface of the transparent substrate; and coarsening the second side surface of the transparent substrate to form a coarse region, wherein an orthographic projection of the coarse region on the transparent substrate coincides with an orthographic projection of the light reflecting structure on the transparent substrate.

In an embodiment of the present disclosure, the coarse region is a portion of a base material of the transparent substrate.

In an embodiment of the present disclosure, the coarsening includes: forming a protective layer on the second side surface of the transparent substrate; patterning the protective layer to form a patterned protective layer, wherein the patterned protective layer has an opening, an orthographic projection of the opening on the transparent substrate coinciding with an orthographic projection of the light reflecting structure on the transparent substrate; coarsening a portion, exposed by the opening, of the second side surface of the transparent substrate to form the coarse region; and removing the patterned protective layer.

In an embodiment of the present disclosure, a material of the protective layer is a negative photoresist, and the patterning includes exposing the negative photoresist using the light reflecting structure as a mask.

In an embodiment of the present disclosure, coarsening the portion, exposed by the opening, of the second side surface of the transparent substrate to form the coarse region includes a wet or dry etching.

In an embodiment of the present disclosure, the base material of the transparent substrate is glass.

In an embodiment of the present disclosure, the wet etching employs an etchant including frost powder, hydrofluoric acid, and hydrochloric acid.

In an embodiment of the present disclosure, the dry etching employs a plasma of at least one of He, CF₄, H₂, and O₂.

In an embodiment of the present disclosure, the light reflecting structure includes a black matrix and a conductive structure.

In an embodiment of the present disclosure, the conductive structure includes at least one of a data line, a data lead, a gate line, and a gate lead formed on the transparent substrate.

Adaptive and further aspects and scope will become apparent from the description provided herein. It should be understood that various aspects of this disclosure may be implemented individually or in combination with one or more other aspects. It should also be understood that the description and specific examples herein are intended for purposes of illustration only and are not intended to limit the scope of the present disclosure.

### BRIEF DESCRIPTION OF THE DRAWINGS

The drawings described herein are for illustrative purposes only of selected embodiments and not all possible implementations, and are not intended to limit the scope of the present application.
FIG. 1 is a schematic view showing a cross section of a display panel without a frame;
FIG. 2 is a schematic view showing a cross section of an array substrate according to an embodiment of the present disclosure;
FIG. 3 is a schematic view showing a cross section of a display panel according to an embodiment of the present disclosure;
FIG. 4 is a flow chart schematically showing a method for manufacturing an array substrate according to an embodiment of the present disclosure;
FIG. 5 is a schematic cross-sectional view showing formation of a protective layer according to an embodiment of the present disclosure;
FIG. 6 is a schematic cross-sectional view schematically showing formation of a patterned protective layer according to an embodiment of the present disclosure;
FIG. 7 is a schematic cross-sectional view schematically showing formation of a coarse region according to an embodiment of the present disclosure;
FIG. 8 is a view schematically showing a optical path of a reflected light when ambient light is incident on an array substrate according to an embodiment of the present disclosure;
FIG. 9 is a schematic view showing a cross section of an array substrate according to an embodiment of the present disclosure.

Corresponding reference numerals indicate corresponding parts or features thcoarseout the several views of the drawings.

### DETAILED DESCRIPTION

As used herein and in the appended claims, the singular form of a word includes the plural, and vice versa, unless the context clearly dictates otherwise. Thus, the references "a", "an", and "the" are generally inclusive of the plurals of the respective terms. Similarly, the words "comprise", "comprises", and "comprising" are to be interpreted inclusively rather than exclusively. Likewise, the terms "include", "including" and "or" should all be construed to be inclusive, unless such a construction is clearly prohibited from the context. Where used herein the term "examples," particularly when followed by a listing of terms is merely exemplary and illustrative, and should not be deemed to be exclusive or comprehensive.

Additionally, further to be noted, when the elements and the embodiments thereof of the present application are introduced, the articles "a/an", "one", "the" and "said" are intended to represent the existence of one or more elements. Unless otherwise specified, "a plurality of' means two or more. The expressions "comprise", "include", "contain" and "have" are intended as inclusive and mean that there may be other elements besides those listed. The terms such as "first" and "second" are used herein only for purposes of description and are not intended to indicate or imply relative importance and the order of formation.

The flow diagrams depicted herein are just one example. There may be many variations to this diagram or the steps (or operations) described therein without departing from the spirit of the invention. For instance, the steps may be performed in a differing order or steps may be added, deleted or modified. All of these variations are considered a part of the claimed invention.

Example embodiments will now be described more fully with reference to the accompanying drawings.

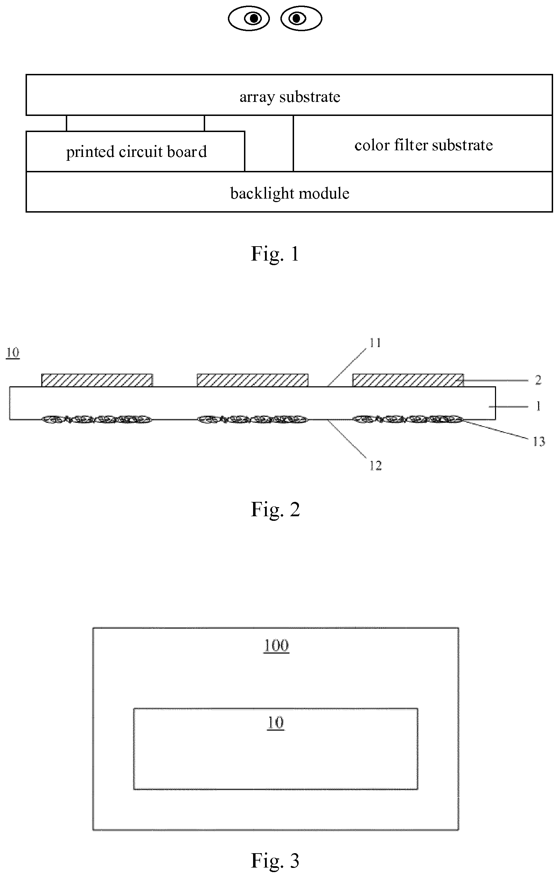

FIG. 1 shows a display panel without a frame. A backlight module and an array substrate are respectively disposed on opposite sides of a color filter substrate. The array substrate is disposed on a display side. When the ambient light is intense, reflection of light on the array substrate is strong, which causes a relatively obvious reflection, thereby affecting the display effect of the display device.

In an embodiment of the present disclosure, an array substrate is provided. A surface of a transparent substrate of the array substrate has a coarse region, which can reduce the reflection of ambient light caused by an undesired reflective structure (for example, a black matrix and a conductive structure) located on the transparent substrate, thereby improving the display effect of the display device.

FIG. 2 is a schematic view showing a cross section of an array substrate according to an embodiment of the present disclosure. As shown in FIG. 2, an array substrate 10 includes: a transparent substrate 1 having a first side surface 11 and a second side surface 12 opposite to the first side surface 11; and a plurality of light reflecting structures 2 located on the first side surface 11 of the transparent substrate 1. The second side surface 12 of the transparent substrate 1 has a plurality of coarse regions 13, an orthographic projection of the coarse region 13 on the transparent substrate 1 coinciding with an orthographic projection of the light reflecting structure 2 on the transparent substrate 1. In an embodiment of the present disclosure, the coarse region 13 is a portion of a surface of a base material of the transparent substrate 1. As an example, the base material of the transparent substrate 1 may be glass. In an embodiment of the present disclosure, the light reflecting structure 2 may include a black matrix and a conductive structure. As an example, the conductive structure may include at least one of a data line, a data lead, a gate line, and a gate lead formed on the transparent substrate 1. In an embodiment of the present disclosure, the light reflecting structure 2 may be made of a metal material.

In the embodiment of the present disclosure, when ambient light is incident on the transparent substrate 1 of the array substrate 10, the light incident on the coarse region 13 is diffusely reflected due to the transparent substrate 1 has the coarse region 13, thereby weakening the reflection of ambient light along a certain direction on the light reflecting structure 2 and thus improving the display effect of the display device.

In an embodiment of the present disclosure, a display panel is provided. FIG. 3 is a schematic structural view showing a display panel according to an embodiment of the present disclosure. As shown in FIG. 3, the display panel 100 includes the array substrate 10 as shown in FIG. 1, so that the display effect of the display panel 100 can be improved.

In an embodiment of the present disclosure, a method for manufacturing an array substrate is provided. It is possible to manufacture an array substrate having a coarse region on a surface of a base material of a transparent substrate, thereby improving the display effect of the display device.

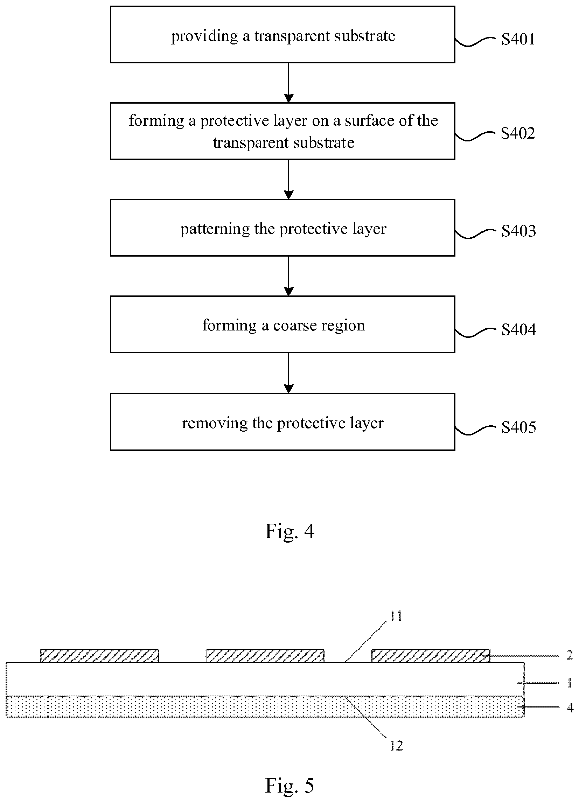

FIG. 4 is a flow chart schematically showing a method for manufacturing an array substrate according to an embodiment of the present disclosure. As shown in FIG. 4, in step S401, a transparent substrate is provided; and in step S402, a protective layer is formed on a surface of the transparent substrate. FIG. 5 is a schematic view showing a cross section of formation of a protective layer according to an embodiment of the present disclosure. As shown in FIG. 5, a transparent substrate 1 having a first side surface 11 and a second side surface 12 opposite to the first side surface 11 is provided, and a plurality of light reflecting structures 2 are disposed on the first side surface 11 of the transparent substrate 1. Next, a protective layer 4 is formed on the second side surface 12 of the transparent substrate 1.

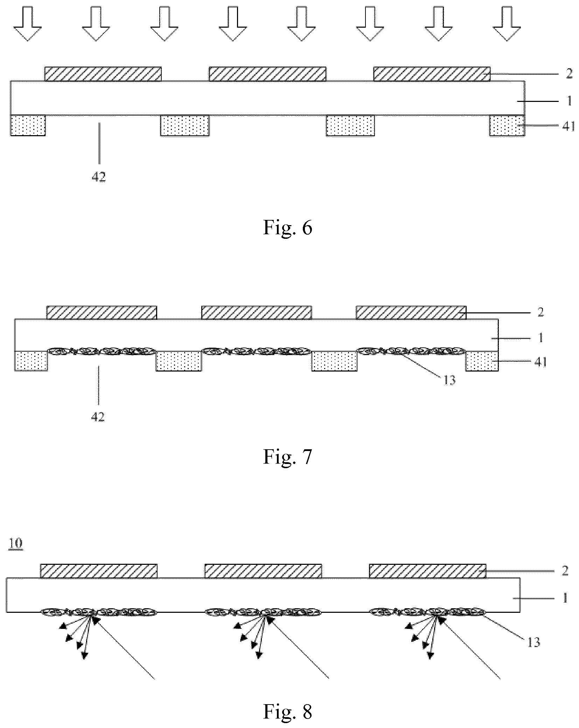

As shown in FIG. 4, in step S403, the protective layer is patterned. FIG. 6 is a schematic view showing a cross section of formation of a patterned protective layer according to an embodiment of the present disclosure. In the embodiment of the present disclosure, the protective layer 4 is patterned to form a patterned protective layer 41. Specifically, the protective layer 4 is exposed to radiation such as ultraviolet rays by using the light reflecting structure 2 as a mask. In an embodiment of the present disclosure, a material of the protective layer 4 is a negative photoresist. In an embodiment of the present disclosure, the patterned protective layer 41 has a plurality of openings 42, an orthographic projection of the opening 42 on the transparent substrate 1 coinciding with an orthographic projection of the light reflecting structure 2 on the transparent substrate 1.

In an embodiment of the present disclosure, the light reflecting structure 2 may include a black matrix and a conductive structure. As an example, the conductive structure may include at least one of a data line, a data lead, a gate line, and a gate lead formed on the transparent substrate 1. In an embodiment of the present disclosure, the light reflecting structure 2 may be made of a metal material.

As shown in FIG. 4, in step S404, a coarse region is formed. FIG. 7 is a schematic view showing a cross section of formation of a coarse region according to an embodiment of the present disclosure. In the embodiment of the present disclosure, the second side surface 12 of the transparent substrate 1 is coarsened to form the coarse region 13. Specifically, as shown in FIG. 7, a portion, exposed by the opening 42, of the second side surface 12 of the transparent substrate 1 is coarsened to form the coarse region 13. In an embodiment of the present disclosure, the coarse region 13 is a portion of a surface of a base material of the transparent substrate 1. As an example, the base material of the transparent substrate 1 is glass. In an embodiment of the present disclosure, the above coarsening may include a wet or dry etching.

As an example, the wet etching employs an etchant including frost powder, hydrofluoric acid, and hydrochloric acid. Specifically, the frost powder, hydrofluoric acid, and hydrochloric acid are mixed to prepare an etchant, and the etchant is then applied (for example, sprayed) to at least a portion, exposed by the opening 42, of the second side surface 12 of the transparent substrate 1, the portion being sufficiently reacted with the etchant to form the coarse region 13.

As an example, the dry etching employs a plasma of at least one of He, CF₄, H₂, and O₂. Specifically, a portion, exposed by the opening 42, of the second side surface 12 of the transparent substrate 1 is physically bombarded with a plasma of at least one of He, CF₄, H₂, and O₂ within a dry etching apparatus, thereby forming the coarse region 13..

As shown in FIG. 4, in step S405, the patterned protective layer is removed. Specifically, the patterned protective layer 41 is removed, thereby manufacturing the array substrate 10 as shown in FIG. 2.

FIG. 8 is a view schematically showing a optical path of a reflected light when ambient light is incident on an array substrate according to an embodiment of the present disclosure. As shown in FIG. 8, when ambient light is incident on the array substrate 10, the light incident on the coarse region 13 is diffusely reflected so that ambient light is reflected in a plurality of directions, thereby reducing reflection of ambient light along a certain direction and thus improving the display effect of the display device.

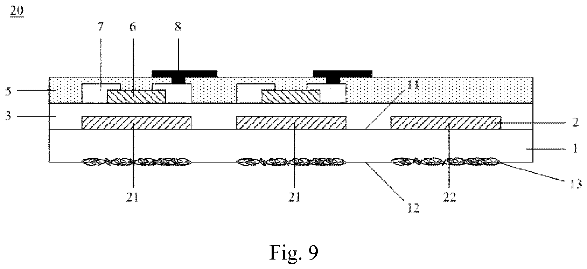

FIG. 9 a schematic view showing a cross section of an array substrate when the conductive structure includes a gate line and a gate lead. As shown in FIG. 9, the array substrate 20 includes: a transparent substrate 1 having a first side surface 11 and a second side surface 12 opposite to the first side surface 11; a coarse region 13 located on the second side surface 12 on the transparent substrate 1; a gate line 21 and a gate lead 22 located on the first side surface 11 of the transparent substrate 1, a material of the gate line 21 and the gate lead 22 being a metal; a gate insulating layer 3 located on the first side surface 11, the gate line 21 and the gate lead 22; an active layer 6 and a source/drain electrode layer 7 located on the gate insulating layer 3; a passivation layer 5 located on the gate insulating layer 3, the active layer 6 and the source/drain electrode layer 7; and a conductive contact 8 connecting to the source/drain electrode layer 7 via a hole in the passivation layer 5. When ambient light is incident on the transparent substrate 1, the light is diffusely reflected on the coarse region 13, which can reduce the reflection of ambient light along a certain direction on the gate line 21 and the gate lead 22 made of metal, thereby improving the display effect of the display device including the array substrate 20.

In an embodiment of the present disclosure, the surface of the base material of the transparent substrate of the array substrate has a coarse region, which can reduce the reflection of ambient light along a certain direction on the black matrix, the gate line, the gate lead, the data line, and the data lead, etc. on the transparent substrate, thereby improving the display effect of the display device.

The foregoing description of the embodiment has been provided for purpose of illustration and description. It is not intended to be exhaustive or to limit the application. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the application, and all such modifications are included within the scope of the application.

## Claims

1. An array substrate, comprising:
a transparent substrate having a first side surface and a second side surface opposite to the first side surface; and
a light reflecting structure disposed on the first side surface of the transparent substrate,
wherein the second side surface of the transparent substrate has a coarse region, an orthographic projection of the coarse region on the transparent substrate coinciding with an orthographic projection of the light reflecting structure on the transparent substrate.

2. The array substrate of claim 1, wherein the coarse region is a portion of a base material of the transparent substrate.

3. The array substrate of claim 1, wherein the light reflecting structure comprises a black matrix and a conductive structure.

4. The array substrate of claim 3, wherein the conductive structure comprises at least one of a data line, a data lead, a gate line, and a gate lead formed on the transparent substrate.

5. The array substrate of claim 2, wherein the base material of the transparent substrate is glass.

6. A display panel comprising the array substrate according to any one of claims 1 to 5.

7. A method for manufacturing an array substrate, comprising:
providing a transparent substrate having a first side surface and a second side surface opposite to the first side surface, a light reflecting structure being disposed on the first side surface of the transparent substrate; and
coarsening the second side surface of the transparent substrate to form a coarse region,
wherein an orthographic projection of the coarse region on the transparent substrate coincides with an orthographic projection of the light reflecting structure on the transparent substrate.

8. The method of claim 7, wherein the coarse region is a portion of a base material of the transparent substrate.

9. The method of claim 7, wherein the coarsening comprises:
forming a protective layer on the second side surface of the transparent substrate;
patterning the protective layer to form a patterned protective layer, wherein the patterned protective layer has an opening, an orthographic projection of the opening on the transparent substrate coinciding with an orthographic projection of the light reflecting structure on the transparent substrate;
coarsening a portion, exposed by the opening, of the second side surface of the transparent substrate to form the coarse region; and
removing the patterned protective layer.

10. The method of claim 9, wherein a material of the protective layer is a negative photoresist, and the patterning comprises exposing the negative photoresist using the light reflecting structure as a mask.

11. The method of claim 9, wherein coarsening the portion, exposed by the opening, of the second side surface of the transparent substrate to form the coarse region comprises a wet or dry etching.

12. The method of claim 11, wherein the base material of the transparent substrate is glass.

13. The method of claim 12, wherein the wet etching employs an etchant comprising frost powder, hydrofluoric acid, and hydrochloric acid.

14. The method of claim 12, wherein the dry etching employs a plasma of at least one of He, CF₄, H₂, and O₂.

15. The method of claim 7, wherein the light reflecting structure comprises a black matrix and a conductive structure.

16. The method of claim 15, wherein the conductive structure comprises at least one of a data line, a data lead, a gate line, and a gate lead formed on the transparent substrate.
